(19) **Europäisches Patentamt European Patent Office Office européen des brevets**

(11) **EP 4 733 609 A1**

(12) **EUROPEAN PATENT APPLICATION**

published in accordance with Art. 153(4) EPC

(43) Date of publication:
29.04.2026 Bulletin 2026/18

(21) Application number: 24861494.3

(22) Date of filing: 12.04.2024

(51) International Patent Classification (IPC):
*F16C 11/04* (2006.01)     *F16C 11/12* (2006.01)
*H05K 5/02* (2006.01)

(52) Cooperative Patent Classification (CPC):
**F16C 11/04; F16C 11/12; H05K 5/02**

(86) International application number:
**PCT/CN2024/087428**

(87) International publication number:
**WO 2025/050644 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 08.09.2023 CN 202322453384 U

(71) Applicant: Honor Device Co., Ltd.
Shenzhen, Guangdong 518040 (CN)

(72) Inventors:
• YANG, Desen
  Shenzhen, Guangdong 518040 (CN)
• ZANG, Yongqiang
  Shenzhen, Guangdong 518040 (CN)
• WU, Ling
  Shenzhen, Guangdong 518040 (CN)
• HUO, Guoliang
  Shenzhen, Guangdong 518040 (CN)

(74) Representative: Isarpatent
Patent- und Rechtsanwälte PartG mbB
Friedrichstraße 31
80801 München (DE)

(54) **SPRING, DAMPING ASSEMBLY AND ELECTRONIC DEVICE**

(57) A spring, a damping assembly, and an electronic device. The electronic device may include any one of a handheld device, an in-vehicle device, a wearable device, a terminal device or connected to a wireless modem, a cellular phone, a smartphone, a personal digital assistant, a computer, a tablet computer, a laptop, or the like. In embodiments of this application, a cross section of a spring wire is a rectangle. Under a same space condition, a coil spring with a rectangular cross section has a higher rigidity, absorbs more energy, and increases a damping force generated by the damping assembly, thereby improving a hand feeling of a user when folding or unfolding the electronic device. When a same damping force is met, the coil spring with a rectangular cross section occupies a smaller space, which facilitates arrangement of another component of the electronic device.

FIG. 9

## Description

This application claims priority to Chinese Patent Application No. 202322453384.X, filed with the China National Intellectual Property Administration on September 8, 2023 and entitled "SPRING, DAMPING ASSEMBLY, AND ELECTRONIC DEVICE", which is incorporated herein by reference in its entirety.

## TECHNICAL FIELD

Embodiments of this application relates to the field of electronic product technologies, and in particular, to a spring, a damping assembly, and an electronic device.

## BACKGROUND

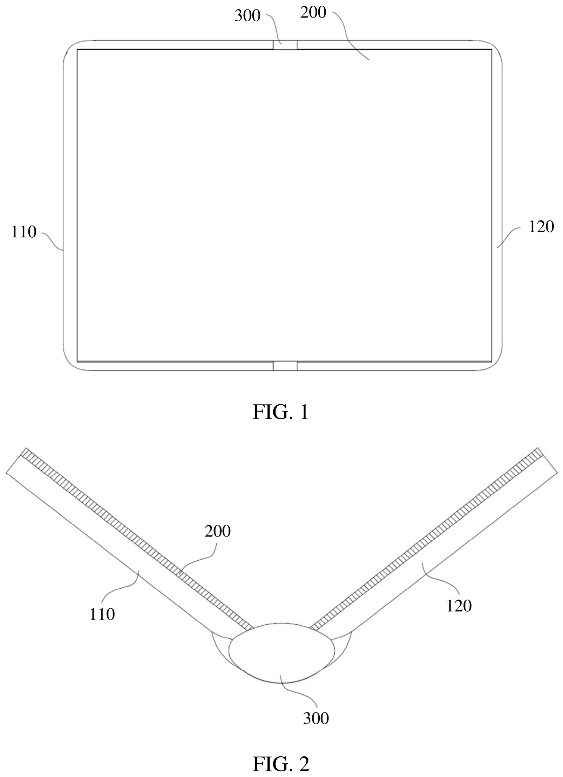

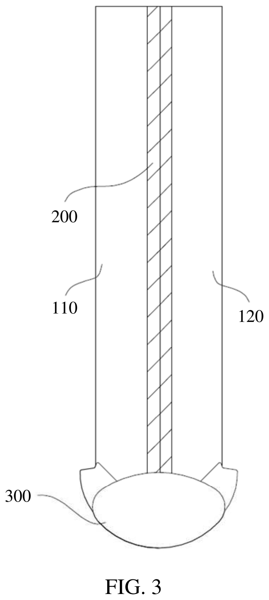

Currently, electronic devices such as laptops and foldable screen phones include a first body, a rotating shaft mechanism, and a second body. The first body and the second body are folded and unfolded relative to each other by using the rotating shaft mechanism. References may be made to FIG. 1 to FIG. 3 for understanding. FIG. 1 to FIG. 3 respectively show schematic diagrams of the electronic device in a flattened state, an intermediate unfolded state, and a folded state.

A damping assembly is usually disposed in the rotating shaft mechanism, and the damping assembly can improve a rotation hand feeling of the rotating shaft mechanism, and can further enable the first body and the second body to hover to a predetermined unfolded location. Currently, the damping assembly usually adopts convex-concave surface matching, a cylindrical spring provides an axial force for convex-concave surface matching, and a spring wire cross section of the cylindrical spring is a circle.

How to minimize a volume of the damping assembly is a technical problem that a person skilled in the art always pays attention when implementing normal functions of the electronic device.

## SUMMARY

Embodiments of this application provide a spring with a relatively high rigidity and occupying a small space, and a damping assembly and an electronic device that include the spring.

According to a first aspect, an embodiment of this application provides a spring, including a spring wire, where the spring wire is spirally wound by N coils to form a columnar structure, and N is an integer greater than or equal to 4. For example, N is equal to 4, 5, 6, 7, 8, or an integer greater than 8. A cross section of the spring wire is a rectangle, and the rectangle includes a first edge and a second edge that are adjacent to each other. A length of the first edge ranges from 0.3 mm to 0.55 mm, and a length of the second edge ranges from 0.3 mm to 0.55 mm. In an ideal state, the first edge and the second edge of the rectangle are perpendicular to each other. However, due to a condition limitation such as a processing technique, the first edge and the second edge may be approximately perpendicular to each other, and a specific deviation is allowed, provided that an overall effect is not affected.

Compared with a spring wire with a circular cross section, under a same space condition, a coil spring with a rectangular cross section has a higher rigidity, absorbs more energy, and increases a damping force generated by a damping assembly, thereby improving a hand feeling of a user when folding or unfolding an electronic device. When a same damping force is met, the coil spring with a rectangular cross section occupies a smaller space, which facilitates arrangement of another component of the electronic device.

In an example, the length of the first edge is greater than the length of the second edge, the first edge extends in an axial direction of the columnar structure, the length of the first edge ranges from 0.45 mm to 0.55 mm, and the length of the second edge ranges from 0.3 mm to 0.35 mm. A space occupied circumferentially by a spring formed by the spring wire within the foregoing range is relatively small, which can meet use requirements of most electronic devices.

In an example, the first edge and the second edge are connected by using an arc, a radius of the arc is greater than or equal to 0.15 mm, and the length of the first edge is greater than or equal to 0.36 mm after the arc is processed. In this embodiment of this application, a corner of the rectangular cross section is in an arc shape, and a stress herein is relatively small, which helps improve working performance and increase a service life of the spring.

In an example, an inner ring of the columnar structure is cylindrical, and a diameter of the inner ring ranges from 0.88 mm to 0.95 mm. The inner ring of the columnar structure is cylindrical. A spring within this size range has a small volume and high working performance, which can meet a small volume design requirement of the electronic device.

In an example, an outer ring of the columnar structure is cylindrical. The outer ring of the columnar structure is cylindrical, and a diameter of the outer ring ranges from 1.65 mm to 1.72 mm. A spring within this size range has a small volume and high working performance, which can meet a small volume design requirement of the electronic device.

In an example, in a non-compressed state, a length of the columnar structure in an axial direction ranges from 7.6 mm to 7.8 mm. A spring within this length range can basically meet damping force requirements of most electronic devices, and occupy a relatively small space.

In an example, an active coil count in the columnar structure ranges from 6 coils to 8 coils, and a total coil count in the columnar structure ranges from 8 coils to 10 coils. A spring coil count within this range meets a damping usage performance requirement, occupies a relatively small space, and facilitates an integral structure layout of the electronic device.

In an example, a pitch of the spring ranges from 0.7 mm to 0.9 mm, where the pitch of the spring in this instance takes into account both a usage requirement and small space occupation.

In an example, the columnar structure includes a first spring wire coil and a second spring wire coil at both end portions, end surfaces of the first spring wire coil and the second spring wire coil that are relatively far away from each other are planes, and the planes are perpendicular to the axial direction of the columnar structure. In this example, the two end surfaces of the columnar structure are planes, which helps increase a contact area between the spring and each of components on both sides thereof, and improve reliability of force transfer and system stability.

In an example, a minimum thickness of each of the first spring wire coil and the second spring wire coil is greater than or equal to 0.4 times an edge length of the rectangular cross section extending in the axial direction. In this way, stability of a system formed by the spring can be improved.

In an example, an angle of a circumference occupied by the plane is greater than 180 degrees. In this way, a contact area between the spring and a contact component thereof is increased as far as possible, improving stability of a system in which the spring is located.

According to a second aspect, an embodiment of this application further provides a damping assembly, including a bracket, a shaft body, a slider, and the spring of any one of the foregoing, where the spring is nested on the shaft body, the slider slides along the shaft body, and the bracket abuts against a concave-convex matching surface of the slider under an action of the spring.

In an example, the bracket includes a first bracket and a second bracket, the shaft body includes a first shaft body and a second shaft body, the first bracket and the second bracket include first end portions relatively close to each other, the first end portion of the first bracket is rotatably connected to the first shaft body, the first end portion of the second bracket is rotatably connected to the second shaft body, the slider is slidably connected to both the first shaft body and the second shaft body, and the slider has concave-convex matching with both the first bracket and the second bracket. In this embodiment, the slider slides along the first shaft body and the second shaft body, and a structure is simple. The first bracket and the second bracket are also connected to the first shaft body and the second shaft body respectively, and are disposed in a compact manner.

In an example, end portions of the first bracket and the second bracket that are relatively far away from each other are second end portions, and the second end portions of the first bracket and the second bracket are respectively configured to be slidably connected to door plates on corresponding sides of an electronic device. Driven by door plates on two sides, the first bracket and the second bracket can rotate relative to corresponding shaft bodies, and motion synchronicity of the bracket and the door plate is relatively high.

In an example, each of the first bracket and the second bracket has a first sleeve and a second sleeve, both the first sleeve and the second sleeve are spaced apart in an axial direction, the slider includes a first slider and a second slider, both the first slider and the second slider are slidably sleeved on the first shaft body and the second shaft body, the spring is sleeved on both the first shaft body and the second shaft body, the spring is press-fitted between the first slider and the second slider, the first slider has concave-convex matching with the first sleeve of the first bracket and the first sleeve of the second bracket, and the second slider has concave-convex matching with the second sleeve of the first bracket and the second sleeve of the second bracket. In this example, both sides of the spring are provided with a slider and a cam portion that has concave-convex matching with the slider to increase a damping force, a structure of the damping assembly is compact, and an occupied space is small.

In an example, an arc recessed surface is further disposed on each of opposite side surfaces of the first bracket and the second bracket to avoid the spring and the slider on a corresponding side.

According to a third aspect, an embodiment of this application further provides an electronic device, including the spring in any one of the foregoing, or the damping assembly in any one of the foregoing.

In an example, the electronic device includes a first body, a second body, and a rotating shaft mechanism, the first body and the second body are able to be folded and unfolded relative to each other under an action of the rotating shaft mechanism, and the rotating shaft mechanism includes at least one damping assembly.

In an example, the electronic device is a foldable screen phone, and the first body and the second body are respectively two middle frames of the foldable screen phone; or

the electronic device is a notebook computer, and the first body and the second body are respectively a display side and a keyboard side of the notebook computer.

The damping assembly and the electronic device provided in embodiments of this application include the foregoing spring. Therefore, both the damping assembly and the electronic device have the foregoing technical effects of the spring.

## BRIEF DESCRIPTION OF DRAWINGS

FIG. 1 is a schematic diagram of a structure of an electronic device in an unfolded state according to an embodiment of this application;
FIG. 2 is a schematic diagram of a structure of the electronic device shown in FIG. 1 in an intermediate unfolded state;
FIG. 3 is a schematic diagram of the electronic device shown in FIG. 1 in a folded state;
FIG. 4 is a schematic diagram of a structure of a rotating shaft mechanism in the electronic device shown in FIG. 1;
FIG. 5 is a schematic diagram of a structure of a damping assembly of the rotating shaft mechanism shown in FIG. 4;
FIG. 6 is a schematic diagram of decomposition of the damping assembly shown in FIG. 4;
FIG. 7 is a schematic diagram of a spring in the damping assembly shown in FIG. 6;
FIG. 8 is a front view of the spring shown in FIG. 7;
FIG. 9 is an A-A sectional view of the spring shown in FIG. 8;
FIG. 10 is a schematic diagram of a cross section of a spring wire shown in FIG. 7;
FIG. 11 is a schematic diagram of a cross section of a spring wire according to another embodiment of this application;
FIG. 12 is a partial enlarged view at A1 in FIG. 9; and
FIG. 13 is a B direction view in FIG. 8.

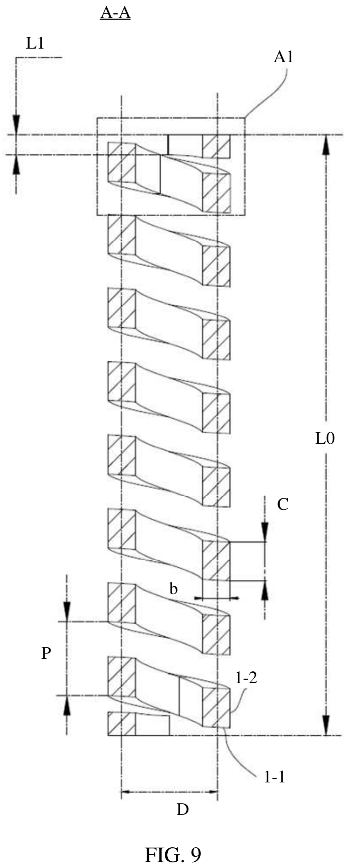

In FIG. 1 to FIG. 13,

110 first body; 120 second body; 200 display screen; 300 rotating shaft mechanism; 310 base; 320 first swing arm; 320 second swing arm; 340 first door plate; 350 second door plate; 360 synchronous assembly; 370 damping assembly; 1 spring; 10 spring wire; 11 active spring coil; 12 first spring wire coil; 13 second spring wire coil; 121 plane; 1211 first boundary; 1212 second boundary;
2 bracket; 21 first bracket; 21a inner hole; 22 second bracket; 201 first sleeve; 202 second sleeve; 203 protruding column; 204 arc recessed surface;
3 shaft body; 31 first shaft body; 32 second shaft body; 301 circlip groove;
4 slider; 41 first slider; 42 second slider; 401 concave-convex surface; 4a through hole
5 circlip

## DESCRIPTION OF EMBODIMENTS

To enable those skilled in the art to better understand technical solutions of embodiments of this application, embodiments of this application are further described in detail in the following with reference to accompanying drawings and specific embodiments.

An embodiment of this application provides a spring with a relatively high rigidity and occupying a relatively small space. The spring may be applied to an electronic device. Certainly, the spring in this embodiment of this application may be further applied to a sliding door, an accessory rotating shaft scenario, or the like. The electronic device may be a mobile terminal such as a mobile phone, a wearable device, an in-vehicle device, an augmented reality (augmented reality, AR)/virtual reality (virtual reality, VR) device, a notebook computer, an ultra-mobile personal computer (ultra-mobile personal computer, UMPC), a netbook, or a personal digital assistant (personal digital assistant, PDA), or may be a professional shooting device, for example, a digital camera, a single lens reflex camera/mirrorless camera, a motion camera, a pan-tilt-zoom camera, or an unmanned aerial vehicle. A specific type of the electronic device is not limited in this embodiment of this application. For ease of understanding, the following uses the electronic device being a foldable screen phone as an example to further introduce the technical solutions and technical effects.

Referring to FIG. 1 again, FIG. 1 is a schematic diagram of a structure of an electronic device according to an embodiment of this application.

The electronic device in this embodiment of this application includes a first body 110, a second body 120, a display screen 200, and a rotating shaft mechanism 300. The first body 110 and the second body 120 are respectively located on two sides of the rotating shaft mechanism 300. Under an action of the rotating shaft mechanism 300, the first body 110 and the second body 120 can be folded and unfolded relative to each other, so as to implement folding and unfolding of the electronic device. FIG. 1 to FIG. 3 respectively show schematic diagrams of the electronic device in a flattened state, an intermediate unfolded state, and a folded state. In FIG. 1, the foldable screen phone is used as an example, and the first body 110 and the second body 120 are respectively two middle frames of the foldable screen phone. When the electronic device is a notebook computer, the first body 110 may be a display side of the notebook computer, and the second body 120 may be a keyboard side of the notebook computer.

In this embodiment of this application, the display screen 200 includes a display module and a transparent cover plate. The display module can display an image, a video, and the like. The display module may use a liquid crystal display 200 (liquid crystal display, LCD), an organic light-emitting diode (organic light-emitting diode, OLED), an active-matrix organic light emitting diode or an active-matrix organic light emitting diode (active-matrix organic light emitting diode, AMOLED), a flex light-emitting diode (flex light-emitting diode, FLED), a quantum dot light emitting diode (quantum dot light emitting diodes, QLED), an electrophoretic (electrophoretic, E-Ink), or the like. Currently, the display screen 200 of the foldable-screen electronic device mostly uses an OLED. The transparent cover plate covers an outer side of the display module to protect the display module. The transparent cover plate may be a glass cover plate, or may be another transparent material with a protective function, for example, the transparent cover plate may be transparent polyimide. The display screen 200 may further have a touch function, that is, the display screen 200 may be a touch screen.

The display screen 200 may be folded and unfolded relative to each other when driven by the first body 110 and the second body 120.

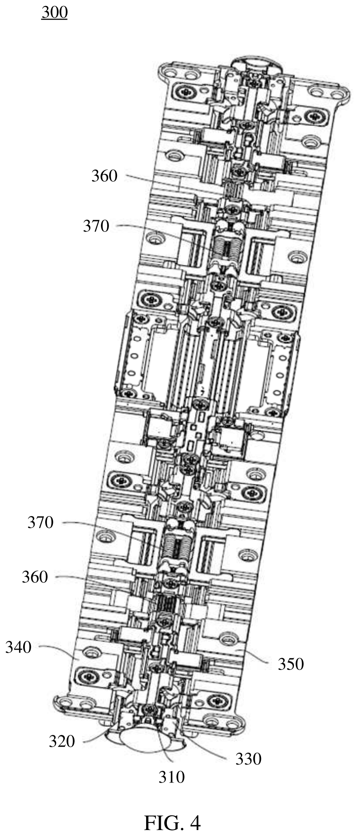

Referring to FIG. 4, in this embodiment of this application, the rotating shaft mechanism 300 includes a base 310, a first door plate 340, a second door plate 350, a first swing arm 320, and a second swing arm 330. The base 310 is located between the first door plate 340 and the second door plate 350. The first swing arm 320 and the second swing arm 330 are symmetrically and rotatably connected to both sides of the base 310. The first swing arm 320 is connected between the first door plate 340 and the base 310. The first swing arm 320 and the first door plate 340 are also rotatably connected. In this way, the first door plate 340 can rotate around the base 310 by using the first swing arm 320. The second swing arm 330 is connected between the second door plate 350 and the base 310. The second swing arm 330 and the second door plate 350 are also rotatably connected. In this way, the second door plate 350 rotates around the base 310 by using the second swing arm 330. Rotation of the swing arm and the door plate and rotation of the swing arm and the base 310 may be implemented in a form of an arc slide groove and an arc block, or certainly may be implemented in another form.

The first door plate 340 and the second door plate 350 may have a same structure, or certainly may have different structures. Likewise, the first swing arm 320 and the second swing arm 330 may have a same structure, or certainly may have different structures.

In this embodiment of this application, the first door plate 340 and the second door plate 350 are respectively fixedly connected to the first body 110 and the second body 120, or the first door plate 340 and the second door plate 350 may be a part of the first body 110 and a part of the second body 120.

The rotating shaft mechanism 300 further includes a synchronous assembly 360 and a damping assembly 370. The synchronous assembly 360 is configured to implement synchronous rotation between the first door plate 340 and the second door plate 350, and the synchronous assembly 360 may be a gear mechanism, or certainly may be a helical mechanism. FIG. 4 shows that the synchronous assembly 360 is in a form of a gear mechanism. A quantity and locations of synchronous assemblies 360 may be properly selected according to a specific structure of the rotating shaft mechanism 300, and an example in which two synchronous assemblies 360 are disposed is shown in FIG. 4.

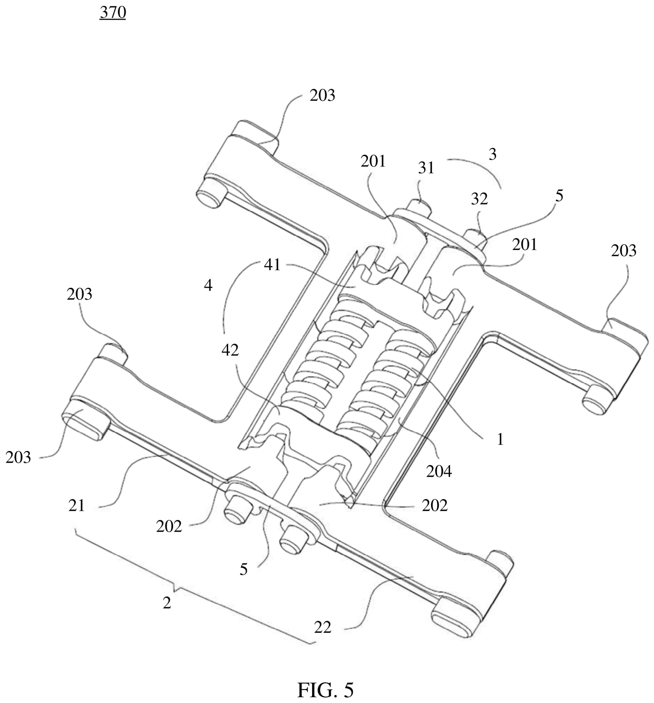

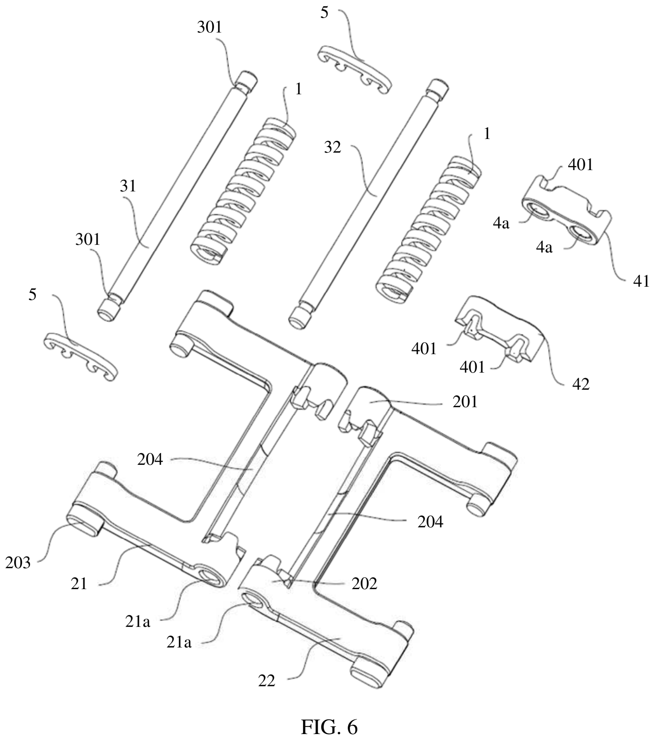

In this embodiment of this application, the damping assembly 370 is configured to generate a damping force during rotation of the first door plate 340 and the second door plate 350. Referring to FIG. 5 and FIG. 6, the damping assembly 370 includes a first shaft body 31, a second shaft body 32, two springs 1, a first slider 41, a second slider 42, a first bracket 21, and a second bracket 22. The first shaft body 31 and the second shaft body 32 are arranged parallel to an axial direction of the rotating shaft mechanism 300, and both are mounted on the base 310. Specifically, two end portions of each of the first shaft body 31 and the second shaft body 32 may be connected to mounting holes of the base 310. Each of the first slider 41 and the second slider 42 runs through both the first shaft body 31 and the second shaft body 32, that is, each of the first slider 41 and the second slider 42 has two through holes 4a, which are respectively sleeved on the first shaft body 31 and the second shaft body 32. Each of the first slider 41 and the second slider 42 is supported on the first shaft body 31 and the second shaft body 32, and can slide along the axial direction relative to the two shaft bodies. A spring 1 is sleeved on each of the first shaft body 31 and the second shaft body 32, and the two springs 1 are press-fitted between the first slider 41 and the second slider 42. End surfaces of the first slider 41 and the second slider 42 that are relatively far away from each other each have two concave-convex surfaces 401.

End portions of the first bracket 21 and the second bracket 22 that are relatively close to each other are defined as first end portions, the first end portion of the first bracket 21 is rotatably connected to the first shaft body 31, and the first end portion of the second bracket 22 is rotatably connected to the second shaft body 32. Specifically, each of the first bracket 21 and the second bracket 22 has two sleeves spaced apart in the axial direction, the two sleeves of the first bracket 21 are coaxial with the first shaft body 31, and the first shaft body 31 runs through inner holes 21a of the two sleeves of the first bracket 21. The two sleeves of the second bracket 22 are coaxial with the second shaft body 32, and the second shaft body 32 runs through inner holes 21a of the two sleeves of the second bracket 22. For ease of description, in this embodiment of this application, the two sleeves spaced apart in the axial direction are respectively defined as a first sleeve 201 and a second sleeve 202. The first slider 41 is located on one side of the two first sleeves 201, and the second slider 42 is located on one side of the two second sleeves 202. Under a restoring force of the spring 1, the two concave-convex surfaces 401 of the first slider 41 convex-concavely abut against and match with the two first sleeves 201, and the two concave-convex surfaces 401 of the second slider 42 convex-concavely abut against and match with the two second sleeves 202.

Structures of the first slider 41 and the second slider 42 may be the same, and structures of the first bracket 21 and the second bracket 22 may also the same.

Axial limiting between both of the first shaft body 31 and the second shaft body 32 and both of the first bracket 21 and the second bracket 22 may be implemented in a manner of a circlip 5 and a circlip groove 301. For example, a circlip groove 301 is disposed on two ends of each of the first shaft body 31 and the second shaft body 32, and a circlip 5 is mounted in the circlip groove 301. The circlips 5 on both ends limit movement of the first bracket 21 and the second bracket 22 relative to the shaft body 31 along the axial direction.

It may be learned from the foregoing description that the damping assembly 370 includes a bracket 2, a shaft body 3, a slider 4, and a spring 1. The bracket has concave-convex matching with the slider, and the bracket 2 abuts against a concave-convex matching surface of the slider 4 under a restoring force of the spring 1. A form of the bracket 2 is not limited to structures of the first bracket 21 and the second bracket 22 described in this embodiment of this application. A quantity of brackets 2 may alternatively one, and a quantity of sliders 4 may alternatively be one, provided that a rotational damping force can be provided for two rotating components.

A protruding column 203 may be disposed on each of second end portions of the first bracket 21 and the second bracket 22 that are relatively far away from each other. The protruding column 203 is in sliding fit with a door plate on a corresponding side, for example, a slide groove (not shown in the figure) is disposed on the door plate, and the protruding column 203 is slidably disposed inside the slide groove.

Certainly, an arc recessed surface 204 is further disposed on each of opposite side surfaces of the first bracket 21 and the second bracket 22 to avoid the spring 1 and the slider 4 on a corresponding side.

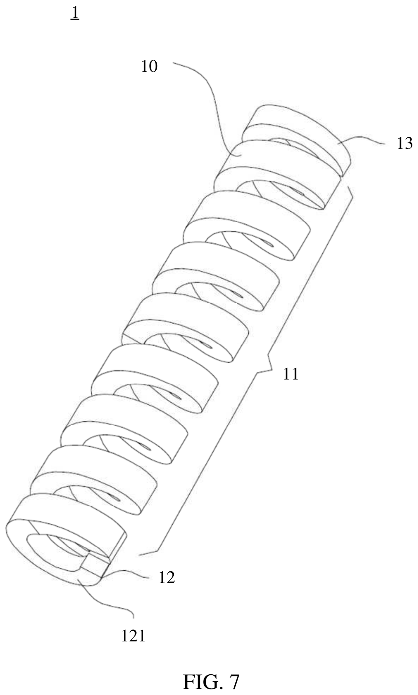

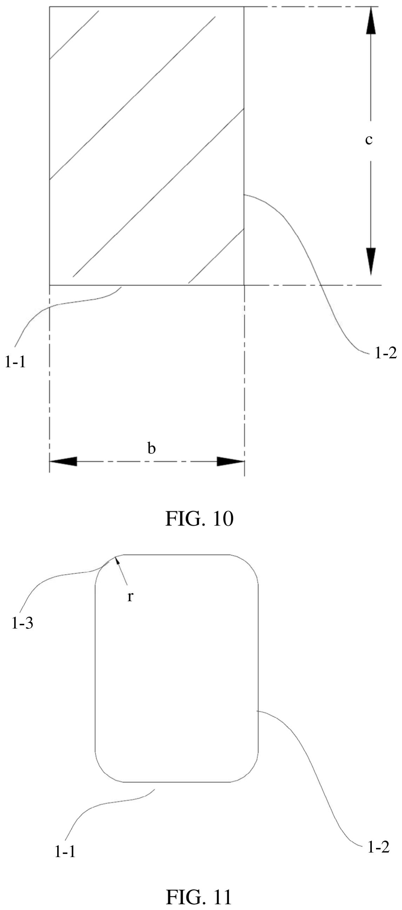

Referring to FIG. 7 to FIG. 9, in this embodiment of this application, the spring 1 in the damping assembly 370 is formed into a helical shape by winding the spring wire 10, and a wound coil count N is an integer greater than or equal to 4. For example, N is equal to 4, 5, 6, 7, 8, or an integer greater than 8. A cross section of the spring wire 10 is a rectangle. It is understood with reference to FIG. 10 that the rectangle includes a first edge 1-2 and a second edge 1-1 that are adjacent to each other. A length c of the first edge 1-2 ranges from 0.3 mm to 0.55 mm, a length b of the second edge 1-1 ranges from 0.3 mm to 0.55 mm. The first edge 1-2 may be a length of the rectangular cross section, and the second edge 1-1 may be a width of the rectangular cross section. The length of the first edge 1-2 and the length of the second edge 1-1 may be any value in the foregoing value ranges. Certainly, a length value of the first edge 1-2 and a length value of the second edge 1-1 may also be the same, and values of the first edge and the second edge may be different. This embodiment of this application shows a specific structure in which the length b of the first edge 1-2 is 0.35 mm, and the length c of the second edge 1-1 is 0.5 mm. Certainly, in another example, the length b of the first edge 1-2 may be 0.4 mm, and the length c of the second edge 1-1 is 0.45 mm.

When the spring wire 10 is a cylindrical spring with a circular cross section, its rigidity $K1 = \dfrac{Ga^4}{5.3 * n * D^3}$ ;

When the spring wire 10 is a cylindrical spring with a rectangular cross section, its rigidity $K2 = \dfrac{Gbc^3}{5.3 * nD^3}$ .

In the two formulas, G indicates a shear modulus of a spring material, where steel G= 8x10$^{10}$ Pa and bronze G=4x10$^{10}$Pa; a represents a diameter size of the circular cross section; n represents an active coil count of the spring, without unit; D represents a pitch diameter size of the spring; b represents a width of the rectangular cross section; and c represents a length of the rectangular cross section.

A rectangular cross section spring and a circular cross section spring of a same active coil count, a same pitch diameter size D, and a same material are used as an example. $\dfrac{K2}{K1} = \dfrac{bc^3}{a^4}$ , for example, a=0.45 mm is used as an example. A circle with this cross section size may form a rectangular cross section with b of 0.35 mm and c of 0.5 mm by using a rolling process, where $\dfrac{K2}{K1} \approx 1.1$ .

As can be learned from the foregoing formula, for the rectangular cross section spring and the circular cross section spring of the same active coil count, the same pitch diameter size D, and the same material, a rigidity of the rectangular cross section spring is increased by about 10% compared with that of the circular cross section spring.

Compared with a circular cross section of the spring wire 10, under a same space condition, a coil spring 1 with a rectangular cross section has a higher rigidity, absorbs more energy, and improves a damping force generated by the damping assembly 370, thereby improving a hand feeling of a user when folding or unfolding the electronic device. When a same damping force is met, the coil spring 1 with a rectangular cross section occupies a smaller space, which facilitates arrangement of another component of the electronic device.

In this embodiment of this application, the length c of the first edge 1-2 is greater than the length b of the second edge, the first edge 1-2 extends in an axial direction of a columnar structure, the length c of the first edge 1-2 ranges from 0.45 mm to 0.55 mm, and the length b of the second edge ranges from 0.3 mm to 0.35 mm. A space occupied circumferentially by a spring 1 formed by the spring wire 10 within the foregoing range is relatively small, which can meet use requirements of most electronic devices.

Referring to FIG. 11, in this embodiment of this application, the first edge 1-2 and the second edge 1-1 are connected by using an arc 1-3, that is, a corner of the rectangular cross section of the spring wire 10 in this embodiment of this application is not a right angle but an arc. A radius of the arc 1-3 is greater than or equal to 0.15 mm, and the length c of the first edge 1-2 is greater than or equal to 0.36 mm. In this embodiment of this application, the corner of the rectangular cross section is in an arc shape, and a stress herein is relatively small, which helps improve working performance and increase a service life of the spring 1.

In conclusion, the rectangle described in this embodiment of this application may be a rectangle in which adjacent edges are perpendicular to each other, or a rectangle with a non-right angle corner and in which adjacent edges are connected by using an arc, a straight line, or the like.

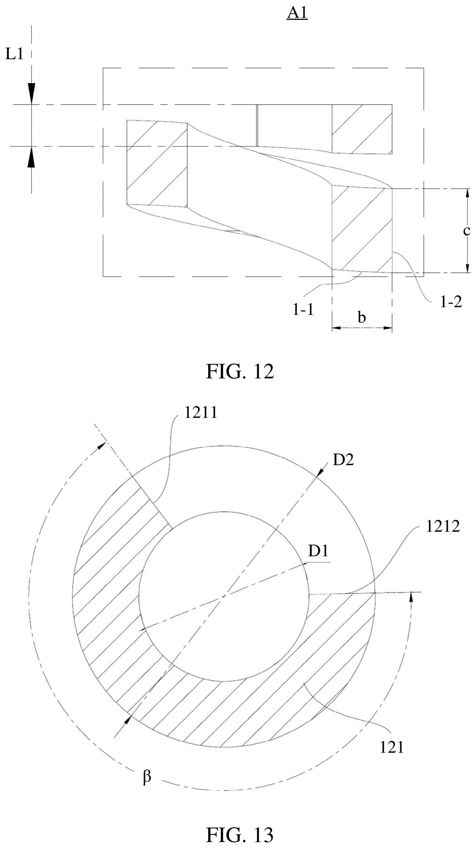

Referring to FIG. 12, in this embodiment of this application, an inner ring of a columnar structure is cylindrical, and a diameter D1 of the inner ring ranges from 0.85 mm to 0.95 mm. In a specific product, D1 may be from 0.88 mm to 0.95 mm.

An outer ring of a columnar structure is also cylindrical, and a diameter D2 of the outer ring ranges from 1.65 mm to 1.72 mm. A spring 1 within this size range has a small volume and high working performance, which can meet a small volume design requirement of the electronic device.

In other words, the spring 1 in this embodiment of this application is also a cylindrical spring 1.

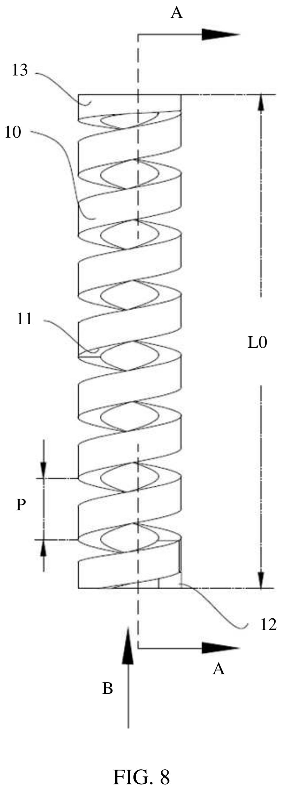

Referring to FIG. 8 again, in this embodiment of this application, when the spring 1 is in a non-compressed state, a length L0 of the columnar structure along the axial direction ranges from 7.6 mm to 7.8 mm. The spring 1 within this length range can basically meet damping force requirements of most electronic devices, and occupies a relatively small space. A pitch p of the spring 1 may range from 0.7 mm to 0.9 mm. In an example, the length L0 of the columnar structure along the axial direction is 7.7 mm, and the pitch p is 0.8 mm.

In this embodiment of this application, the active coil count of the columnar structure ranges from 6 coils to 8 coils, for example, the active coil count may be 6, 7, or 8 coils. A total coil count of the columnar structure ranges from 8 coils to 10 coils, for example 8, 9, or 10 coils. A first spring wire coil 12 and a second spring wire coil 13 of the spring 1 that are located at outermost ends are basically incomplete coils, and a coil between the first spring wire coil 12 and the second spring wire coil 13 is an active spring coil 11. A quantity of active spring coils 11 is an active coil count, and the total coil count is approximately equal to the active coil count plus 2. Certainly, a special case in which a difference of 1 or 0 exists between the total coil count and the active coil count is also not excluded. The coil count of the spring 1 within this range meets a damping usage performance requirement, and a relatively small space is occupied.

The above parameters can be configured properly according to a specific product. The following table provides several specific spring configuration parameters.

| Spring sequence number | C/mm | b/mm | p/mm | L0/mm | D1/mm | D2/mm | Active coil count | Total coil count |
|---|---|---|---|---|---|---|---|---|
| 1 | 0.5 | 0.4 | 0.7 | 7.6 | 0.9 | 1.6 | 8 | 10 |
| 2 | 0.5 | 0.35 | 0.75 | 7.6 | 0.88 | 1.68 | 7 | 9 |
| 3 | 0.5 | 0.35 | 0.75 | 7.7 | 0.9 | 1.65 | 8 | 10 |
| 4 | 0.45 | 0.35 | 0.8 | 7.7 | 0.91 | 1.64 | 7 | 9 |
| 5 | 0.5 | 0.45 | 0.8 | 7.75 | 0.9 | 1.62 | 6 | 8 |
| 6 | 0.4 | 0.4 | 0.9 | 7.8 | 0.89 | 1.6 | 6 | 8 |

A force test experiment is performed on the spring in the above table. A test condition is as follows: The spring is pre-compressed for 10 times with a stroke of 5.85 mm to 5.05 mm, and then for one time with a stroke of 5.75 mm on one side. When the spring is compressed to a minimum length, pressure is always greater than 22 N.

A service life test condition is as follows: The spring is compressed for 400,000 times with a stroke of 5.85 mm to 5.05 mm. Attenuation of a force value does not exceed 15%.

Referring to FIG. 13, in this embodiment of this application, the columnar structure includes the first spring wire coil 12 and the second spring wire coil 13 at both end portions, end surfaces of the first spring wire coil 12 and the second spring wire coil 13 that are relatively far away from each other are planes 121, and the planes 121 are perpendicular to the axial direction of the columnar structure. To better distinguish a plane region, in the figure, the plane region is coated with a shadow. The figure shows only a plane on an outer end of the first spring wire coil 12. A plane on an outer end of the second spring wire coil 13 may be understood with reference to the plane on the outer end of the first spring wire coil 12. Plane sizes on the two ends may be the same or certainly different.

In this example, the two end surfaces of the columnar structure are planes, which helps increase a contact area between the spring and each of components on both sides thereof, and improve reliability of force transfer and system stability.

Referring to FIG. 12 again, to prevent buckling on two ends of the spring, in this embodiment of this application, a minimum thickness L1 of each of the first spring wire coil and the second spring wire coil is greater than or equal to 0.4 times an edge length of the rectangular cross section extending in the axial direction. For example, when c is 0.5 mm, the thickness L1 of the outermost spring wire coil is not less than 0.2 mm. In this way, stability of a system formed by the spring 1 can be improved.

To further improve stability of the spring, an angle β of a circumference occupied by the plane 121 is greater than 180 degrees. As shown in FIG. 13, FIG. 13 shows two boundaries in the plane on the outer end of the first spring wire coil 12 that is located below: a first boundary 1211 and a second boundary 1212. An included angle β between the first boundary 1211 and the second boundary 1212 is greater than 180 degrees. In this way, a contact area between the spring and a contact component thereof is increased as far as possible.

A material of the spring wire may be SAE6150 chromium vanadium steel, INCONEL -750, INCONEL -718, NIMONIC 90, or the like.

This embodiment of this application is described by using an example in which the spring is applied to the damping assembly. Certainly, the spring in this embodiment of this application may alternatively be applied to another location to provide an elastic force requirement.

For another structure of the electronic device, refer to the conventional technology.

All of the damping assembly, the rotating shaft mechanism, and the electronic device provided in this embodiment of this application include the foregoing spring. Therefore, all of the damping assembly, the rotating shaft mechanism, and the electronic device also have the foregoing technical effects of the spring.

In this embodiment of this application, the terms "first" and "second" are merely used for the purpose of description, and should not be understood as an indication or implication of relative importance or an implicit indication of a quantity of indicated technical features. Therefore, a feature defined with "first" or "second" may explicitly or implicitly include one or more such features.

Orientation terms such as "inside" and "outside" mentioned in the embodiments of this application merely refer to directions in the accompanying drawings. Therefore, the used orientation terms are intended for better and clearer description and understanding of the embodiments of this application, and are not intended for indicating or implying that an indicated apparatus or element needs to have a specific orientation or constructed and operated in a specific orientation, and therefore shall not be construed as limitations on the embodiments of this application.

In the descriptions of embodiments of this application, the term "include", "comprise", or any other variant thereof is intended to cover non-exclusive inclusion, so that a process, method, item, or apparatus that includes a series of elements includes not only those elements but also other elements that are not explicitly listed, or includes elements inherent to such a process, method, item, or apparatus.

In the embodiments of this application, the term "and/or" is merely used to describe an association relationship between associated objects, and represents that three relationships may exist. For example, A and/or B may represent the following three cases: Only A exists, both A and B exist, and only B exists. In addition, the character "/" in this specification usually represents an "or" relationship between associated objects.

The foregoing is merely example implementations of this application. It should be noted that a person of ordinary skill in the art can further make some improvements and polishing without departing from the principles of this application, and the improvements and polishing shall fall within the protection scope of this application.

**Claims**

1. A spring, comprising a spring wire, wherein the spring wire spirals N coils to form a columnar structure, a cross section of the spring wire is a rectangle, the rectangle comprises a first edge and a second edge that are adjacent to each other, a length of the first edge ranges from 0.3 mm to 0.55 mm, and a length of the second edge ranges from 0.3 mm to 0.55 mm; wherein N is a natural number greater than or equal to 4.

2. The spring according to claim 1, wherein the length of the first edge is greater than the length of the second edge, the first edge extends in an axial direction of the columnar structure, the length of the first edge ranges from 0.45 mm to 0.55 mm, and the length of the second edge ranges from 0.3 mm to 0.35 mm.

3. The spring according to claim 2, wherein the first edge and the second edge are connected by using an arc, a radius of the arc is greater than or equal to 0.15 mm, and the length of the first edge is greater than or equal to 0.36 mm.

4. The spring according to claim 1, wherein an inner ring of the columnar structure is cylindrical, and a diameter of the inner ring ranges from 0.88 mm to 0.95 mm.

5. The spring according to claim 4, wherein an outer ring of the columnar structure is cylindrical, and a diameter of the outer ring ranges from 1.65 mm to 1.72 mm.

6. The spring according to claim 1, wherein in a non-compressed state, a length of the columnar structure in an axial direction ranges from 7.6 mm to 7.8 mm.

7. The spring according to claim 1, wherein an active coil count in the columnar structure ranges from 6 coils to 8 coils, and a total coil count of the columnar structure ranges from 8 coils to 10 coils.

8. The spring according to claim 1, wherein a pitch of the spring ranges from 0.7 mm to 0.9 mm.

9. The spring according to any one of claims 1 to 8, wherein the columnar structure comprises a first spring wire coil and a second spring wire coil at both end portions, end surfaces of the first spring wire coil and the second spring wire coil that are relatively far away from each other are planes, and the planes are perpendicular to the axial direction of the columnar structure.

10. The spring according to claim 9, wherein a minimum thickness of each of the first spring wire coil and the second spring wire coil is greater than or equal to 0.4 times an edge length of the rectangular cross section extending in the axial direction.

11. The spring according to claim 9, wherein an angle of a circumference occupied by the plane is greater than 180 degrees.

12. A damping assembly, comprising a bracket, a shaft body, a slider, and the spring according to any one of claims 1 to 11, wherein the spring is nested on the shaft body, the slider slides along the shaft body, and the bracket abuts against a concave-convex matching surface of the slider under an action of the spring.

13. The damping assembly according to claim 12, wherein the shaft body comprises a first shaft body and a second shaft body, the slider is slidably connected to both the first shaft body and the second shaft body, the bracket comprises a first bracket and a second bracket, the first bracket and the second bracket comprise first end portions relatively close to each other, the first end portion of the first bracket is rotatably connected to the first shaft body, the first end portion of the second bracket is rotatably connected to the second shaft body, and the slider has concave-convex matching with both the first bracket and the second bracket.

14. The damping assembly according to claim 13, wherein end portions of the first bracket and the second bracket that are relatively far away from each other are second end portions, and the second end portions of the first bracket and the second bracket are respectively configured to be slidably connected to door plates on corresponding sides of an electronic device.

15. The damping assembly according to claim 14, wherein each of the first bracket and the second bracket has a first sleeve and a second sleeve, both the first sleeve and the second sleeve are spaced apart in an axial direction, the slider comprises a first slider and a second slider, both the first slider and the second slider are slidably sleeved on the first shaft body and the second shaft body, the spring is sleeved on both the first shaft body and the second shaft body, the spring is press-fitted between the first slider and the second slider, the first slider has concave-convex matching with the first sleeve of the first bracket and the first sleeve of the second bracket, and the second slider has concave-convex matching with the second sleeve of the first bracket and the second sleeve of the second bracket.

16. The damping assembly according to claim 15, wherein an arc recessed surface is further disposed on each of opposite side surfaces of the first bracket and the second bracket to avoid the spring and the slider on a corresponding side.

17. An electronic device, comprising the spring according to any one of claims 1 to 11, or the damping assembly according to any one of claims 12 to 16.

18. The electronic device according to claim 17, wherein the electronic device comprises a first body, a second body, and a rotating shaft mechanism, the first body and the second body are able to be folded and unfolded relative to each other under an action of the rotating shaft mechanism, and the rotating shaft mechanism comprises at least one damping assembly.

19. The electronic device according to claim 18, wherein the electronic device is a foldable screen phone, and the first body and the second body are respectively two middle frames of the foldable screen phone; or
the electronic device is a notebook computer, and the first body and the second body are respectively a display side and a keyboard side of the notebook computer.

300   200

110                                    120

FIG. 1

200

110                            120

300

FIG. 2

FIG. 3

300

360

370

370

360

340

350

320

330

310

FIG. 4

370

FIG. 5

FIG. 6

<u>1</u>

10

13

11

12

121

FIG. 7

FIG. 8

FIG. 9

FIG. 10

FIG. 11

A1

L1

c

1-1

b

1-2

FIG. 12

1211

D2

D1

1212

121

β

FIG. 13

## INTERNATIONAL SEARCH REPORT

| International application No. |
| --- |
| **PCT/CN2024/087428** |

**A. CLASSIFICATION OF SUBJECT MATTER**

F16C 11/04(2006.01)i; F16C 11/12(2006.01)i; H05K 5/02(2006.01)i

According to International Patent Classification (IPC) or to both national classification and IPC

**B. FIELDS SEARCHED**

Minimum documentation searched (classification system followed by classification symbols)

IPC:F16C, H05K

Documentation searched other than minimum documentation to the extent that such documents are included in the fields searched

Electronic data base consulted during the international search (name of data base and, where practicable, search terms used)

CNABS; CNTXT; VEN; CNKI: 弹簧, 截面, 方形, 矩形, 阻尼, 电子设备, 平板, 手提电脑, 手机, 智能机, spring, cross section, rectangular, square, damp, electronic device, tablet, laptop, computer, smart, phone

**C. DOCUMENTS CONSIDERED TO BE RELEVANT**

| Category* | Citation of document, with indication, where appropriate, of the relevant passages | Relevant to claim No. |
| --- | --- | --- |
| X | CN 104948624 A (GUANGXI UNIVERSITY) 30 September 2015 (2015-09-30) description, paragraphs 20-29, and figure 4 | 1-11 |
| Y | CN 104948624 A (GUANGXI UNIVERSITY) 30 September 2015 (2015-09-30) description, paragraphs 20-29, and figure 4 | 12-19 |
| Y | CN 116357660 A (HONOR DEVICE CO., LTD.) 30 June 2023 (2023-06-30) description, paragraphs 57-85 and 99-108, and figures 1-10 | 12-19 |
| A | CN 2755349 Y (AOSIDA AUTOMOBILE SPARES CO., LTD., SHIYAN) 01 February 2006 (2006-02-01) entire document | 1-19 |
| A | CN 116044888 A (HONOR DEVICE CO., LTD.) 02 May 2023 (2023-05-02) entire document | 1-19 |
| A | US 2008191400 A1 (LIU QINGLIANG) 14 August 2008 (2008-08-14) entire document | 1-19 |
| A | CN 204921801 U (ZHUJI KANGYU SPRING CO., LTD.) 30 December 2015 (2015-12-30) entire document | 1-19 |

✓ Further documents are listed in the continuation of Box C.    ✓ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **21 June 2024** | **20 July 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2024/087428** |

**C.    DOCUMENTS CONSIDERED TO BE RELEVANT**

| Category* | Citation of document, with indication, where appropriate, of the relevant passages | Relevant to claim No. |
|---|---|---|
| A | CN 206392852 U (WUHAN LITONG SPRING CO., LTD.) 11 August 2017 (2017-08-11) entire document | 1-19 |

Form PCT/ISA/210 (second sheet) (July 2022)

**INTERNATIONAL SEARCH REPORT**
Information on patent family members

International application No.

**PCT/CN2024/087428**

| Patent document cited in search report | | | Publication date (day/month/year) | Patent family member(s) | Publication date (day/month/year) |
|---|---|---|---|---|---|
| CN | 104948624 | A | 30 September 2015 | None | |
| CN | 116357660 | A | 30 June 2023 | None | |
| CN | 2755349 | Y | 01 February 2006 | None | |
| CN | 116044888 | A | 02 May 2023 | None | |
| US | 2008191400 | A1 | 14 August 2008 | None | |
| CN | 204921801 | U | 30 December 2015 | None | |
| CN | 206392852 | U | 11 August 2017 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202322453384X